# EUROPÄISCHE PATENTSCHRIFT

(11) **EP 1 282 171 B1**
(45) Veröffentlichungstag und Bekanntmachung des Hinweises auf die Patenterteilung: **15.06.2011**
(21) Anmeldenummer: 02015001.7
(22) Anmeldetag: 04.07.2002
(51) Int. Cl.: H01L 25/075, G02F 1/13357, H01L 33/50

(54) **Planare Lichtquelle auf LED-Basis**
LED-based planar light-source
Source lumineuse plane à base de diodes électroluminescentes

(30) Priorität: 31.07.2001 DE 10137042
(43) Veröffentlichungstag der Anmeldung: 05.02.2003
(73) Patentinhaber: OSRAM Gesellschaft mit beschränkter Haftung, 81536 München (DE)
(72) Erfinder: Ellens, Andries, Dr., 2561 SL Den Haag (NL); Schliep, Karl-Peter, 81737 München (DE); Zwaschka, Franz, Dr., 85737 Ismaning (DE)

(56) Entgegenhaltungen:
- GB-A- 2 311 643
- JP-A- 10 319 877

## Beschreibung

### Technisches Gebiet

Die Erfindung betrifft eine Planare Lichtquelle auf LED-Basis gemäß dem Oberbegriff des Anspruchs 1. Es handelt sich dabei insbesondere um eine planare Lichtquelle für LCD-Hinterleuchtung oder auch für andere Anwendungen, die insbesondere voll farbtauglich ist und außerdem eine hohe Leuchtdichte besitzt.

### Stand der Technik

Aus der JP-A 7-176794 ist bereits eine Planare Lichtquelle auf LED-Basis bekannt, bei der eine blaue LED mittels teilweiser Konversion durch einen gelb-orangen Leuchtstoff weißes Licht auf einer planaren Fläche erzeugt. Diese einfache komplementäre Mischung ermöglicht jedoch keine gute Farbwiedergabe.

Ein aufwendigeres Konzept mit besserer Farbwiedergabe ist die Dreifarbenmischung. Hierbei werden zur Erzeugung von weiß durch Mischung die Grundfarben Rot-Grün-Blau (RGB) herangezogen. Dabei kann entweder eine blaue LED zur teilweisen Konversion zweier Leuchtstoffe, die rot und grün emittieren, herangezogen werden (WO 00/33390) oder es wird eine UV-emittierende LED verwendet, die drei Leuchtstoffe, die jeweils ihre Emission im Roten, Grünen und Blauen haben, angeregt, siehe WO 97/48138 sowie JP-10-319877 und GB 2 311 643 A. Beispiele sind Linienemitter wie YOB:Ce,Tb (grün) und YOS:Eu (rot) Hierbei ist jedoch eine relativ kurzwellige Emission (UV-Bereich < 370 nm) erforderlich um hohe Quantenausbeuten erreichen zu können. Dies bedingt den Einsatz von Saphir-Substraten für die UV-LED, die sehr teuer sind. Verwendet man andererseits eine UV-LED auf Basis der billigeren SiC-Substrate, so muss man sich mit einer Emission im Bereich 380 bis 420 nm zufriedengeben, was den Einsatz von Linienemittern im Grünen und Roten Schwierig bis unmöglich macht. Bei blauen Leuchtstoffen führt dies zu Absorptionsproblemen.

Ein spezifisches Problem hier ist außerdem der zusätzliche Absorptionsverlust blauer Strahlung durch die Breitbandigkeit der Absorption der rot und grün emittierenden Leuchtstoffe. Dies alles zusammen führt zu deutlichen Einschränkungen bei der Einstellung der Lichtfarbe bzw. der Lichtausbeute.

### Darstellung der Erfindung

Es ist Aufgabe der vorliegenden Erfindung, eine vollfarbtaugliche planare Lichtquelle gemäß dem Oberbegriff des Anspruchs 1 bereitzustellen, die eine hohe Lichtausbeute erreicht und trotzdem wirtschaftlich ist.

Diese Aufgabe wird durch die kennzeichnenden Merkmale des Anspruchs 1 gelöst. Besonders vorteilhafte Ausgestaltungen finden sich in den abhängigen Ansprüchen.

Planare Lichtquellen, wie sie beispielsweise in Grundzügen in der US-A 5 619 351 beschrieben sind, werden oft für die Hinterleuchtung von LCDs verwendet. Dabei wird als Lichtquelle bisher überwiegend eine kompakte Leuchtstofflampe verwendet. Dies erfordert eine hohe Versorgungsspannung und schafft Probleme mit der elektromagnetischen Verträglichkeit, weshalb der Ersatz der Lampen durch LED erstrebenswert ist.

Erfindungsgemäß wird eine planare Lichtquelle, die vollfarbtauglich ist, unter Ausnutzung des RGB-Prinzips bereitgestellt, wobei die Strahlung einer Vielzahl von flächenhaft angeordneten UV-Dioden mittels Konversion durch Leuchtstoffe in längerwelliges Licht umgewandelt wird. Unter dem Begriff UV wird hier der Bereich von 300 bis 420 nm verstanden. Die Strahlung der UV-Dioden wird allein durch grün (bevorzugt mit einer Peakemissionswellenlänge zwischen 510 und 560 nm, z.B. SrAl₂O₄:Eu²⁺ oder Eu²⁺-basierte Thiogallate) und rot emittierende Leuchtstoffe (bevorzugt mit einer Peakemissionswellenlänge von mehr als 590 nm bis hin zu 690 nm, z.B. Sr₂Si₅N₈:Eu²⁺) absorbiert, während die blaue Komponente (bevorzugt mit einer Peakemissionswellenlänge zwischen 430 und 490 nm) von blau emittierenden LEDs bereitgestellt wird. Dieses Prinzip ist an sich überraschend, weil es auf den ersten Blick wesentlich aufwendiger wirkt als die bekannten Lösungen, da mehr LEDs verwendet werden und diese, zumindest in zwei Gruppen (UV-LEDs und blaue LEDs) getrennt, angesteuert werden müssen.

Dabei ist aber zu berücksichtigen, dass der Preis für blaue LEDs günstiger als der Preis für UV-LEDs ist und dass andererseits einige UV-LEDs eingespart werden können. Außerdem liefert eine räumliche Trennung der blauen LEDs von den roten und grünen Leuchtstoffen eine elegante Möglichkeit, die teilweise Absorption der blauen Strahlung der LEDs durch diese RG-Leuchtstoffe zu vermeiden. Somit kann mit weniger Kosten eine effizientere Lichtquelle geschaffen werden. Schließlich ist es mit besonderen Vorteilen verbunden, dass als UV-LED eine billige GaN-basierte LED (bevorzugt mit In und/oder Al dotiert) auf SiC-Substrat mit Emissionspeak zwischen 380 und 420 nm verwendet werden kann statt einer teuren UV-LED auf Saphirsubstrat mit Emissionspeak unter 380 nm. Denn eine geringe Überlappung zwischen dem Emissionsspektrum der UV-LED und einem Absorptionsspektrum eines etwaigen blau emittierenden Leuchtstoffs spielt bei der erfindungsgemäßen Konzeption keinerlei Rolle, während sie bei der Konversion von UV in Blau (> 380 nm) schlechtere Ergebnisse liefert. In bezug auf den rot bzw. grün emittierenden Leuchtstoff, die beide u. U. den gleichen Aktivator verwenden, insbesondere Eu, spielt dieser Energieabstand (Überlapp) zwischen Anregungsquelle und Absorptionskurve des Leuchtstoffs keine wesentliche Rolle mehr. Generell zeigt sich, dass das Absorptionsproblem bei breitbandig emittierenden Leuchtstoffen, insbesondere ab ca. 490 nm Peakemission, keine Rolle mehr spielt. Das Konzept der vorliegenden Erfindung kann deshalb nicht nur bei RGB-Mischungen angewendet werden sondern, sondern schließt auch die Anwendung zusätzlicher Leuchtstoffe mit ein. Eine weitere Anwendung ist schließlich die Erzeugung einer weißen Lichtquelle auf dem einfacheren Prinzip der Blau-Gelb-Mischung, entsprechend den ersten weiß emittierenden LEDs aus dem Stand der Technik. Dabei wird hier die blaue Komponente durch die primäre Emission einer Anzahl blauer LEDs und die gelbe Komponente durch die gelbe Emission eines geeigneten Leuchtstoffs unter Anregung einer Anzahl UV-Leds bereitgestellt. Eine weitere Anwendung ist außerdem die Bereitstellung einer planaren Lichtquelle mit spezifischer Farbe, wobei diese Spezialfarbe durch Mischung einer blauen und einer weiteren Komponente herstellbar ist. Dabei wird wieder die blaue Komponente durch die primäre Emission einer Anzahl blauer LEDs und die weitere Komponente durch die Emission eines (oder auch mehrerer weiterer) geeigneten Leuchtstoffs unter Anregung einer Anzahl UV-Leds bereitgestellt, wobei sich die gewünschte Farbe durch die Mischung der Emissionen ergibt. Konkrete Beispiele für derartige Leuchtstoffe haben z.B. Peakemissionen im Blau-Grün (z.B. Sr₆BP₅O₂₀:Eu²⁺, Sr₄Al₁₄O₂₅:Eu²⁺) oder Grün-Gelb oder Gelb (z.B. Sr₂Si₅N₈:Ce³⁺, (Sr,Ba)SiO₄:Eu²⁺) oder Gelb-Orange (z.B. Ca₂Si₅N₈:Eu²⁺, Ca_{1.5}Al₃Si₉N¹⁶:Eu²⁺).

Im Prinzip können die RG-Leuchtstoffe direkt auf den einzelnen UV-LEDs platziert sein. Vorteilhaft sind die rot und grün emittierenden Leuchtstoffe auf einem beabstandet von den UV-Dioden angebrachten Lichtleiter oder auf einer transparenten Platte mit Lichtleiterwirkung aufgetragen oder darin implementiert, weil sich durch den Abstand eine bessere Gleichmäßigkeit der flächenhaften Emission ergibt. Die Anzahl der blau emittierenden LEDs pro Baueinheit ist höchstens gleich der Anzahl der UV-Dioden. Im Falle, dass die blau emittierenden LEDs flächig angeordnet sind, entspricht sie in etwa der Anzahl der UV-Dioden (entsprechend 50 bis 100 %).

Eine wesentliche Reduktion der Anzahl der blau emittierenden LEDs (typisch um 10 bis 40 %) kann erreicht werden, wenn die blau emittierenden LEDs zeilenförmig am Rand der mit UV-LEDs bestückten Fläche angeordnet sind. Sie werden dann mittels geeigneter, an sich bekannter Techniken in die nach vorne gerichtete Emission der Fläche eingekoppelt. Im einfachsten Fall wird eine einzige Zeile seitlich an einer Randleiste neben einem Feld von UV-Dioden angeordnet. Typisch erfolgt dabei die Einkopplung mittels einer keilförmigen (oder auch ebenen) Scheibe, die punktuelle Ätzungen in unterschiedlicher Dichte aufweist, so dass insgesamt eine gleichmäßige Helligkeit der Fläche erreicht wird.

Diese Technik kann jedoch dahingehend modifiziert werden, dass mehrere Randleisten mit zeilenförmig angeordneten LEDs bestückt werden. Im einfachsten Fall werden also zwei Zeilen seitlich neben Rändern einer Fläche von UV-Dioden angeordnet. Geht man von einer rechtwinkligen Fläche aus, so können die zwei Zeilen im rechten Winkel zueinander stehen oder parallel zueinander auf gegenüberliegenden Rändern angeordnet sein.

### Figuren

Im folgenden soll die Erfindung anhand mehrerer Ausführungsbeispiele näher erläutert werden. Es zeigen:
- Figur 1: eine planare Lichtquelle, im Schnitt;
- Figur 2: ein Emissions- und Reflexionsspektrum eines grün emittierenden Leuchtstoffs;
- Figur 3: ein Emissions- und Reflexionsspektrum eines rot emittierenden Leuchtstoffs;
- Figur 4: ein Emissionsspektrum einer erfindungsgemäßen Beleuchtungseinheit, verglichen mit einer konventionellen Beleuchtungseinheit;
- Figur 5: ein Emissionsspektrum einer erfindungsgemäßen Beleuchtungseinheit, mit und ohne eigene Blaukomponente.

### Beschreibung der Zeichnungen

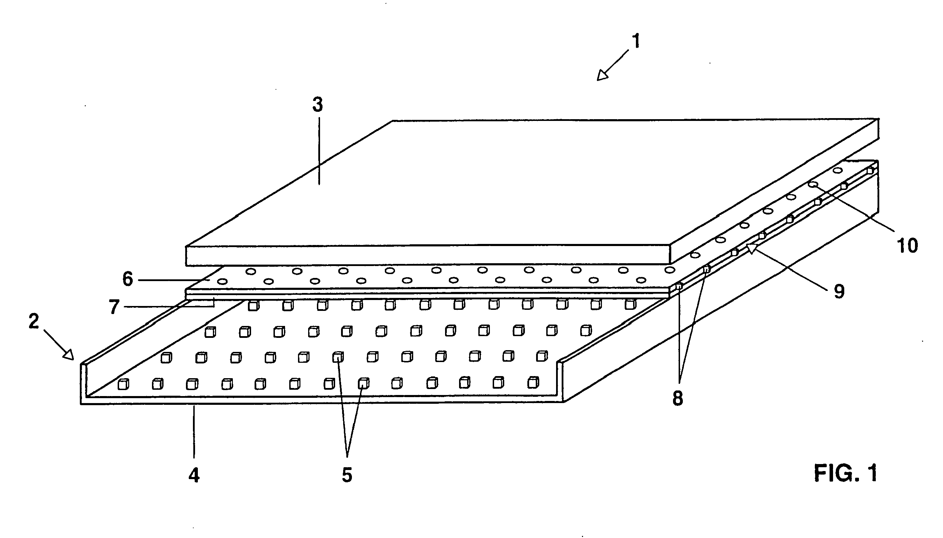

Die Figur 1 zeigt eine LCD-Anzeigevorrichtung 1 mit einer planaren Lichtquelle 2 für die Hinterleuchtung eines LCD-Displays 3. Ein zusätzlich vorhandenes rechteckiges Gehäuse ist der Einfachheit halber weggelassen, desgleichen übliche Zusatzkomponenten wie Polarisations- und Farbfilter und Ansteuereinheiten (beispielsweise TFT). Die planare Lichtquelle 2 besteht aus einem Grundkörper 4, auf dem ein Array von UV-Dioden 5 rasterförmig gleichmäßig beabstandet angeordnet ist. Vor dem Grundkörper 4 ist eine Lichtleiterplatte 6, die keilförmig sein kann (Keilform ist nicht dargestellt), beabstandet und parallel dazu aufgesetzt. Die Platte 6 besitzt Mittel zur Auskopplung zur gleichmäßigen Abstrahlung von seitlich eingestrahltem Licht nach oben. Bei einer keilförmigen Platte können diese Koppelzentren gleichmäßig auf der Oberfläche der Platte verteilt. Bei einer planparallelen Platte ist die Anordnungder Zentren ungleichmäßig, da nur so eine gleichmäßig über die Oberflähce der Platte verteilte Abstrahlung des blauen Lichts bewirkt werden kann. Auf der den UV-LEDs zugewandten Seite ist die Platte 6 mit einer Beschichtung 7 versehen, die aus einer Mischung von zwei Leuchtstoffen mit grüner und roter Emission besteht. Die UV-Strahlung der Dioden 5 (InGaN mit 390 nm Peakemissionswellenlänge) wird hier fast vollständig in rotes und grünes Licht umgewandelt.

Seitlich an einem Rand der transparenten Platte 6 (aus Glas, Kunststoff, PET oder ähnlichem) ist eine Zeile von blau emittierenden LEDs 8 angebracht, deren Licht in die Platte 6 emittiert wird und durch die Koppelzentren 10 auf der Oberfläche der Platte 6 (beispielsweise Ätzungen an der Vorderseite der Platte oder Mikroprismen, o.ä.) nach vorne ausgekoppelt wird. Das blaue Licht mischt sich mit dem grünen und roten Licht aus der Beschichtung 7 zu weiß.

Die beiden Typen von LEDs 5, 8 werden getrennt angesteuert (nicht dargestellt) und können dadurch auf einen gewünschten Farbort eingestellt oder auch nachgeregelt werden.

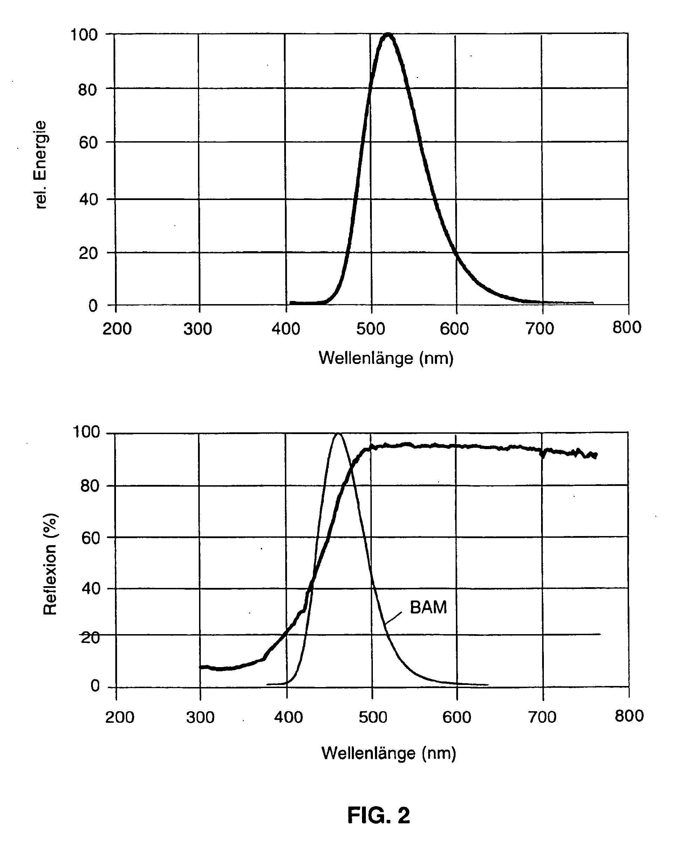

Zum besseren Verständnis der Wirkungsweise und Vorteile ist in Figur 2 das Emissionsspektrum und Reflexionsspektrum eines vorteilhaft verwendeten grün emittierenden Leuchtstoffs SrAl₂O₄:Eu²⁺ mit Emissionspeakwellenlänge bei 524 nm gezeigt. Das Reflexionsspektrum zeigt zugleich auch das Absorptionsverhalten wegen des bekannten Zusammenhangs R(%) = 100% - A (%) mit R = Reflexion und A = Absorption. Des weiteren ist im Reflexionsspektrum das Emissionsspektrum eines typisch beim Stand der Technik verwendeten blau emittierenden Leuchtstoffs (BaMgAl₁₀O₁₇:Eu, bekannt als BAM) eingezeichnet. Deutlich wird hier erkennbar, dass die blaue Strahlung des BAM durch den grünen Leuchtstoff in hohem Maße absorbiert würde. Dieses Problem wird durch das Konzept der vorliegenden Erfindung vollständig vermieden.

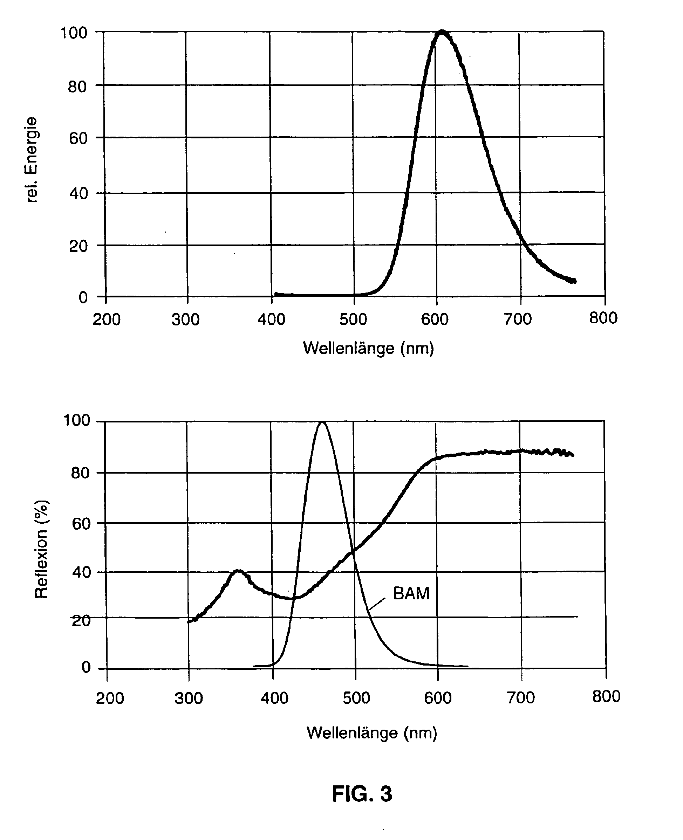

In ähnlicher Weise zeigt Figur 3 das Emissionsspektrum und Reflexionsspektrum eines vorteilhaft verwendeten rot emittierenden Leuchtstoffs Sr₂Si₅N₈:Eu²⁺ mit Emissionspeakwellenlänge bei 623 nm. Auch hier ist im Reflexionsspektrum die Emission eines typisch beim Stand der Technik verwendeten blau emittierenden Leuchtstoffs (BAM) eingezeichnet. Auch in diesem Fall wäre eine teilweise Absorption der blauen Strahlung durch den roten Leuchtstoff wirksam.

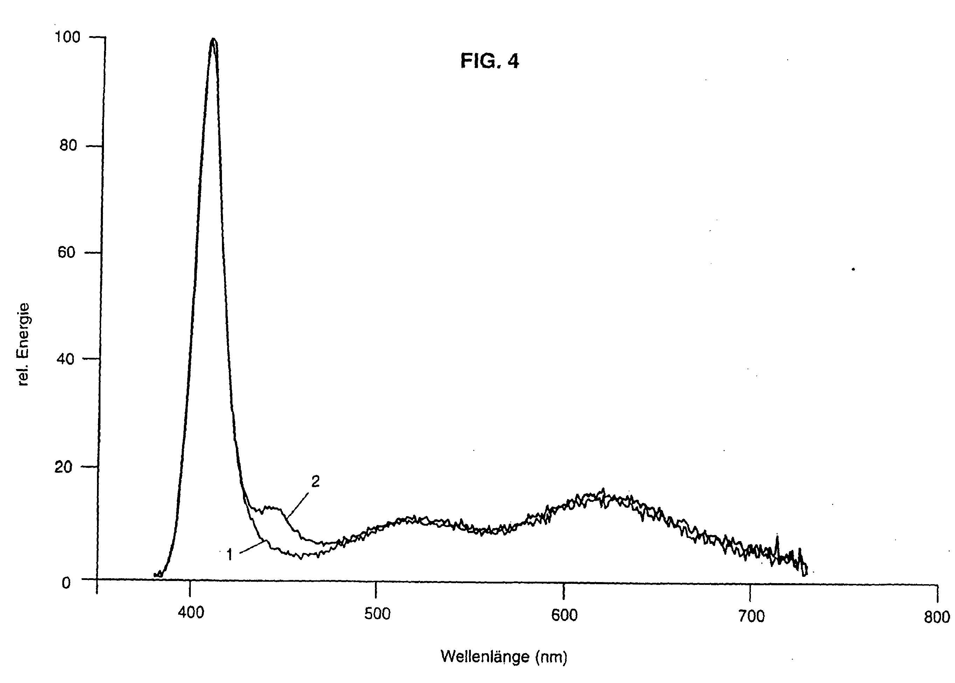

Figur 4 zeigt das Emissionsspektrum einer erfindungsgemäßen planaren Lichtquelle mit UV-Dioden-Array, wobei zu Vergleichszwecken die Konversion der UV-Strahlung durch eine vorbekannte Leuchtstoffmischung aus RGB-Leuchtstoffen wie oben beschrieben dargestellt ist (1). Erfindungsgemäß wird eine Zeile von blau emittierenden LEDs statt des blauen Leuchtstoffs verwendet(2). Diese Anordnung zeigt eine Steigerung der Effizienz um 30 % (weil absorbierende Mechanismen entfallen) unter Verzicht auf 10 % der Zahl der UV-LEDs (ursprünglich 50). Statt dessen wird eine Zeile blauer LEDs (10 Stück) verwendet.

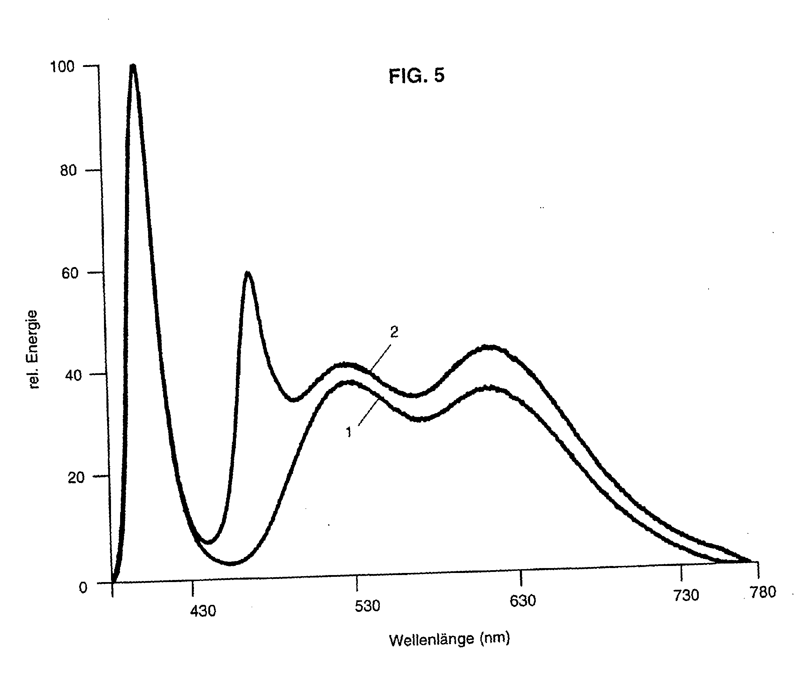

Figur 5 zeigt das Emissionsspektrum einer erfindungsgemäßen planaren Lichtquelle mit UV-Dioden-Array (Peakwellenlänge 405 m), wobei zu Vergleichszwecken die Konversion der UV-Strahlung durch eine vorbekannte Leuchtstoffmischung aus RG-Leuchtstoffen wie oben beschrieben dargestellt ist (1). Erfindungsgemäß wird eine Zeile von blau emittierenden LEDs (Peakwellenlänge 460 nm) eingekoppelt (2). Diese Anordnung ist so eingestellt, dass das resultierende Spektrum in der Nähe des Weißpunktes liegt. Zu diesem Zweck muss der Anteil der blauen Strahlung verglichen mit den Grün- und Rotanteilen deutlich höher liegen um die im Blauen niedrige Empfindlichkeit des menschlichen Auges zu berücksichtigen.

Eine besonders vorteilhafte Ausnutzung des neuen Mischprinzips besteht darin, ganz bewusst möglichst einen roten Leuchtstoff und auch einen grünen Leuchtstoff zu wählen, der jeweils zumindest einen Teil der blauen Primärstrahlung (LED) absorbiert. Vorteilhaft absorbiert zumindest einer der Leuchtstoffe die blaue Primärstrahlung möglichst vollständig. Dadurch dass die Zumischung der blauenStrahlung im Strahlengang erst nach der Konversion erfolgt, wird eine Absorption der blauen Strahlung trotzdem vermieden. Ein Teil der blauen Strahlung, die in Vorwärtsrichtung umgelenkt wird, wird jedoch an Grenzflächen zurückgestreut, durchquert daher die Leuchtstoffschicht und wird dort zumindest teilweise konvertiert und teilweise wieder in Vorwärtsrichtung emittiert. Dieser eigentlich verlorene Teil der blauen Strahlung wird somit der nutzbaren Strahlung hinzugefügt, während er ohne Absorptionsmöglichkeit durch den roten Leuchtstoff, in geringerem Umfang auch durch den grünen Leuchtstoff, nicht genutzt werden könnte und eher zu einer unerwünschten Aufheizung der Lichtquelle führen würde.

Das gleiche Konzept lässt sich natürlich auch bei einem gelben Leuchtstoff realisieren.

## Patentansprüche

1. Planare Lichtquelle auf LED (Licht emittierende Dioden) Basis unter Ausnutzung des Farbmischprinzips, wobei die Strahlung von flächenhaft angeordneten UV-emittierenden Dioden (5) mittels Konversion durch mindestens einen UV-absorbierenden Leuchtstoff in längerwelliges Licht umgewandelt wird, und wobei dieses Licht mit einer blauen Komponente gemischt wird, **dadurch gekennzeichnet, dass** die Strahlung der UV-Dioden (5) durch den mindestens einen Leuchtstoff (7) absorbiert wird, während die blaue Komponente von mindestens einer blau emittierenden LED (8) bereitgestellt wird.

2. Planare Lichtquelle nach Anspruch 1, **dadurch gekennzeichnet, dass** die Strahlung der UV-Dioden (5) von rot und grün emittierenden Leuchtstoffen (7) absorbiert wird, um unter Ausnutzung des RGB-Prinzips eine weiß emittierende Lichtquelle bereitzustellen.

3. Planare Lichtquelle nach Anspruch 1, **dadurch gekennzeichnet, dass** die Strahlung der UV-Dioden (5) von einem gelb emittierenden Leuchtstoff (7) absorbiert wird, um unter Ausnutzung des Blau-Gelb-Misch-Prinzips eine weiß emittierende Lichtquelle bereitzustellen.

4. Planare Lichtquelle nach Anspruch 1, **dadurch gekennzeichnet, dass** die Strahlung der UV-Dioden (5) von einem oder mehreren farbig emittierenden Leuchtstoffen (7) absorbiert wird, um unter Ausnutzung des Farb-Misch-Prinzips eine farbig emittierende Lichtquelle bereitzustellen.

5. Planare Lichtquelle nach Anspruch 1, **dadurch gekennzeichnet, dass** die UV-absorbierenden Leuchtstoffe (7) auf einen beabstandet von den UV-Dioden (5) angebrachten Lichtleiter oder auf eine transparente Platte (6) aufgebracht sind.

6. Planare Lichtquelle nach Anspruch 1, **dadurch gekennzeichnet, dass** die Anzahl der blau emittierenden LEDs höchstens gleich der Anzahl der UV-Dioden ist.

7. Planare Lichtquelle nach Anspruch 1, **dadurch gekennzeichnet, dass** die blau emittierenden LEDs flächig angeordnet sind.

8. Planare Lichtquelle nach Anspruch 1, **dadurch gekennzeichnet, dass** die blau emittierenden LEDs zeilenförmig angeordnet sind.

9. Planare Lichtquelle nach Anspruch 8, **dadurch gekennzeichnet, dass** eine Zeile (9) blau emittierender LEDs neben einem Feld von UV-Dioden angeordnet ist.

10. Planare Lichtquelle nach Anspruch 8, **dadurch gekennzeichnet, dass** mindestens zwei Zeilen blau emittierender LEDs neben Rändern einer Fläche von UV-Dioden angeordnet sind.

11. Planare Lichtquelle nach Anspruch 1, **dadurch gekennzeichnet, dass** als UV-Diode eine GaN-basierte LED auf SiC-Substrat eingesetzt wird.

12. Planare Lichtquelle nach Anspruch 1, **dadurch gekennzeichnet, dass** die Peakwellenlänge der primären UV-Emission bei 300 bis 420 nm liegt, dass die Peakwellenlänge der blauen Emission bei 430 bis 490 nm liegt, dass die sekundäre Emission des grünen und roten Leuchtstoffs eine Peakwellenlänge von 510 bis 560 bzw. 590 bis 680 nm aufweist.

13. Planare Lichtquelle nach Anspruch 1, **dadurch gekennzeichnet, dass** die Zumischung der blauen Komponente der Strahlung erst nach der Konversion der UV-Strahlung erfolgt.

14. Planare Lichtquelle nach Anspruch 1, **dadurch gekennzeichnet, dass** das Absorptionsspektrum zumindest des roten Leuchtstoffs sich zumindest teilweise mit dem Emissionsspektrum der blauen LEDs überlappt.

## Claims

1. LED (Light-Emitting Diode)-based planar light source utilizing the colour mixing principle, the radiation from UV-emitting diodes (5) arranged in a planar fashion being converted into light of longer wavelength by means of conversion by at least one UV-absorbing phosphor, and this light being mixed with a blue component, **characterized in that** the radiation of the UV diodes (5) is absorbed by the at least one phosphor (7) while the blue component is provided by at least one blue-emitting LED (8).

2. Planar light source according to Claim 1, **characterized in that** the radiation of the UV diodes (5) is absorbed by red- and green-emitting phosphors (7) in order to provide a white-emitting light source by utilizing the RGB principle.

3. Planar light source according to Claim 1, **characterized in that** the radiation of the UV diodes (5) is absorbed by a yellow-emitting phosphor (7) in order to provide a white-emitting light source by utilizing the blue-yellow mixing principle.

4. Planar light source according to Claim 1, **characterized in that** the radiation of the UV diodes (5) is absorbed by one or a plurality of colour-emitting phosphors (7) in order to provide a colour-emitting light source by utilizing the colour mixing principle.

5. Planar light source according to Claim 1, **characterized in that** the UV-absorbing phosphors (7) are applied to an optical conductor fitted at a spacing from the UV diodes (5), or to a transparent plate (6).

6. Planar light source according to Claim 1, **characterized in that** the number of the blue-emitting LEDs is at most equal to the number of the UV diodes.

7. Planar light source according to Claim 1, **characterized in that** the blue-emitting LEDs are arranged in a planar fashion.

8. Planar light source according to Claim 1, **characterized in that** the blue-emitting LEDs are arranged in rows.

9. Planar light source according to Claim 8, **characterized in that** a row (9) of blue-emitting LEDs is arranged next to an array of UV diodes.

10. Planar light source according to Claim 8, **characterized in that** at least two rows of blue-emitting LEDs are arranged next to edges of a surface of UV diodes.

11. Planar light source according to Claim 1, **characterized in that** an GaN-based LED on an SiC substrate is used as UV diode.

12. Planar light source according to Claim 1, **characterized in that** the peak wavelength of the primary UV emission is at 300 to 420 nm, **in that** the peak wavelength of the blue emission is at 430 to 490 nm, and **in that** the secondary emission of green and red phosphors has a peak wavelength of 510 to 560 or 590 to 680 nm.

13. Planar light source according to Claim 1, **characterized in that** the admixture of the blue component of the radiation is performed only after the conversion of the UV radiation.

14. Planar light source according to Claim 1, **characterized in that** the absorption spectrum at least of the red phosphor overlaps at least partially with the emission spectrum of the blue LEDs.

## Revendications

1. Source lumineuse plane à base de DEL (DEL), utilisant le principe du mélange de couleurs, le rayonnement de diodes émettrices d'ultraviolets (5) agencées de manière bidimensionnelle étant transformé en lumière de longueur d'onde plus longue au moyen d'une conversion réalisée grâce à au moins une matière luminescente absorbant les ultraviolets et cette lumière étant mélangée à une composante bleue, **caractérisée en ce que** le rayonnement des diodes à ultraviolets (5) est absorbé par la au moins une matière luminescente (7) tandis que la composante bleue est fournie par au moins une DEL émettant dans le bleu (8).

2. Source lumineuse plane selon la revendication 1, **caractérisée en ce que** le rayonnement des diodes à ultraviolets (5) est absorbé par des matières luminescentes (7) émettant dans le rouge et dans le vert afin d'obtenir une source lumineuse émettant dans le blanc en tirant parti du principe RVB.

3. Source lumineuse plane selon la revendication 1, **caractérisée en ce que** le rayonnement des diodes à ultraviolets (5) est absorbé par une matière luminescente (7) émettant dans le jaune afin d'obtenir une source lumineuse émettant dans le blanc en tirant parti du principe du mélange du bleu et du jaune.

4. Source lumineuse plane selon la revendication 1, **caractérisée en ce que** le rayonnement des diodes à ultraviolets (5) est absorbé par une ou plusieurs matière/s luminescente/s (7) émettant dans les couleurs afin de fournir une source lumineuse émettant dans les couleurs en tirant parti du principe du mélange de couleurs.

5. Source lumineuse plane selon la revendication 1, **caractérisée en ce que** la matière luminescente (7) absorbant les ultraviolets est appliqué sur un guide d'onde installé à une distance des diodes à ultraviolets (5) ou sur une plaque transparente (6).

6. Source lumineuse plane selon la revendication 1, **caractérisée en ce que** le nombre de DEL émettant dans le bleu est au plus égal au nombre des diodes à ultraviolets.

7. Source lumineuse plane selon la revendication 1, **caractérisée en ce que** les DEL émettant dans le bleu sont agencées de manière bidimensionnelle.

8. Source lumineuse plane selon la revendication 1, **caractérisée en ce que** les DEL émettant dans le bleu sont agencées en lignes.

9. Source lumineuse plane selon la revendication 8, **caractérisée en ce qu'**une ligne (9) de DEL émettant dans le bleu est située près d'un champ de diodes à ultraviolets.

10. Source lumineuse plane selon la revendication 8, **caractérisée en ce qu'**au moins deux lignes de DEL émettant dans le bleu sont situées près des bords d'une surface de diodes à ultraviolets.

11. Source lumineuse plane selon la revendication 1, **caractérisée en ce que** l'on utilise, en tant que diode à ultraviolets, une DEL à base de GaN sur un substrat SiC.

12. Source lumineuse plane selon la revendication 1, **caractérisée en ce que** la longueur d'onde de crête de l'émission d'ultraviolets primaire est comprise entre 300 et 420 nm, **en ce que** la longueur d'onde de crête de l'émission dans le bleu est comprise entre 430 et 490 nm, **en ce que** l'émission secondaire de la matière luminescente verte et rouge a une longueur d'onde de crête comprise entre 510 et 560 nm resp. 590 et 680 nm.

13. Source lumineuse plane selon la revendication 1, **caractérisée en ce que** l'addition et le mélange de la composante bleue au rayonnement n'ont lieu qu'après la conversion du rayonnement ultraviolet.

14. Source lumineuse plane selon la revendication 1, **caractérisée en ce que** le spectre d'absorption d'au moins la matière luminescente rouge chevauche au moins partiellement le spectre d'émission des DEL bleues.
